Europäisches Patentamt

European Patent Office

Office européen des brevets

(19)

(11) Numéro de publication : **0 533 539 A1**

# (12) DEMANDE DE BREVET EUROPEEN

(21) Numéro de dépôt : **92402489.6**

(22) Date de dépôt : **11.09.92**

(51) Int. Cl.$^5$ : **H04N 7/13,** H04N 7/137,
H03M 7/30

(30) Priorité : **20.09.91 FR 9111609**

(43) Date de publication de la demande :
**24.03.93 Bulletin 93/12**

(84) Etats contractants désignés :
**DE GB IT NL**

(71) Demandeur : **THOMSON-CSF**
**51, Esplanade du Général de Gaulle**
**F-92800 Puteaux (FR)**

(72) Inventeur : **Burel, Gilles**
**THOMSON-CSF, SCPI, Cédex 67**
**F-92045 Paris la Défense (FR)**

(74) Mandataire : **Benoit, Monique et al**
**THOMSON-CSF, SCPI, B.P. 329, 50, rue**
**Jean-Pierre Timbaud**
**F-92402 Courbevoie Cédex (FR)**

(54) **Procédé de compression d'images.**

(57) Procédé de compression d'images comprenant deux étapes (1, 5). Une première étape de quantification vectorielle (1) comprime une image source (2) en une image des index (4) cohérente par rapport à l'image source (2). Une deuxième étape (5) comprime à nouveau cette image des index (5) suivant une méthode de prédiction utilisant un réseau de neurones multicouches.

Application : compression d'images pour le stockage et la transmission de celles-ci.

FIG.1

EP 0 533 539 A1

La présente invention concerne un procédé de compression d'images. Elle s'applique notamment dans les domaines de la transmission ou du stockage d'images.

La compression d'images consiste à réduire la quantité de données nécessaire pour représenter une image. La quantification vectorielle exposée dans l'article de R. M. GRAY "Vector Quantization" paru dans la revue IEEE. ASSP Magazine d'Avril 1984 est une méthode de compression d'images qui a été largement utilisée. Cette méthode consiste à découper l'image en blocs et à remplacer chaque bloc par un index. Cet index se rapporte à un dictionnaire contenant un nombre limité de blocs représentatifs. La constitution du dictionnaire est réalisée suivant l'algorithme des "k-means" développé dans l'article de J. MAC QUEEN "Some methods for classification and analysis of multivariate observations" paru dans le catalogue " 5th Berkeley Symposium on Mathematics, statistic and probabilities" de 1967 ou suivant l'algorithme LBG exposé dans l'article de Y. LINDE, A. BUZO et R.M. GRAY "An algorithm for Vector Quantizer Design" paru dans la revue IEEE Communications de Janvier 1980.

L'utilité de la compression est évidente quand il s'agit de transmettre ou de stocker des images. Néanmoins, les méthodes précitées ont encore des taux de compression médiocres et il n'est pas toujours possible de réduire de façon significative la quantité de données nécessaire à la représentation de l'image tout en conservant à celle-ci une bonne qualité. Ces faibles taux de compression entraînent des problèmes de place mémoire dans les systèmes de stockage ou d'encombrement dans les lignes de transmission dont les bandes passantes ne sont pas extensibles.

Le but de l'invention est de pallier les inconvénients précités. A cet effet, l'invention a pour objet un procédé de compression d'images comprenant une première étape de quantification vectorielle où une image source est découpée en blocs, chaque bloc étant comparé aux éléments d'un dictionnaire en vue de le remplacer par l'index de l'élément du dictionnaire qui s'en rapproche le plus, de manière à obtenir une image comprimée et cohérente par rapport à l'image source cette première étape étant suivie d'une deuxième étape de compression de l'image comprimée suivant une méthode de prédiction, caractérisée en ce que le le dictionnaire est construit suivant un algorithme qui réalise des mises à jour successives des éléments du dictionnaire et de domaines associés à ces éléments, ces donmaines comprenant des blocs d'images issus d'un ensemble d'apprentissage réalisé à partir d'une ou plusieurs images, les mises à jour des éléments du dictionnaire et des domaines faisant intervenir des interactions topologiques qui permettent de conserver la cohérence topologique du dictionnaire.

L'invention a pour principal avantage qu'elle permet d'améliorer le taux de compression de l'image sans perte de qualité au niveau de celle-ci.

D'autres caractéristiques et avantages de l'invention apparaîtront à l'aide de la description qui suit, faite en regard des dessins annexés qui représentent :

La figure 1 : un organigramme de la compression d'images selon l'invention.

La figure 2 : une illustration de l'algorithme de construction d'un dictionnaire de blocs de pixels améliorant les performances du procédé selon l'invention.

La figure 3a : une illustration des blocs du dictionnaire utilisé par l'invention et des blocs issus d'un ensemble d'apprentissage.

La figure 3b : une illustration des domaines associés à chacun des blocs du dictionnaire utilisé par l'invention.

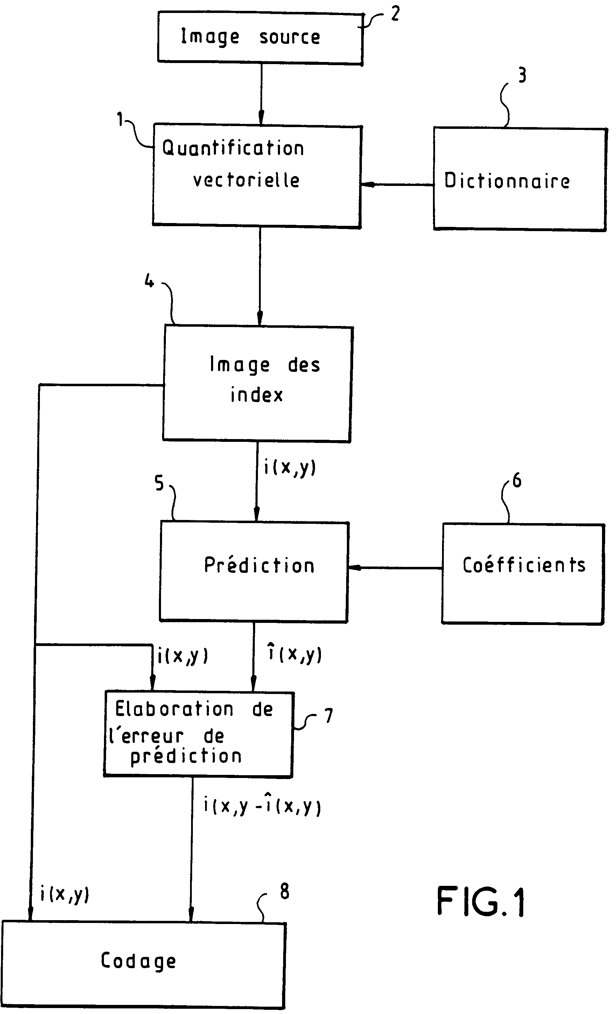

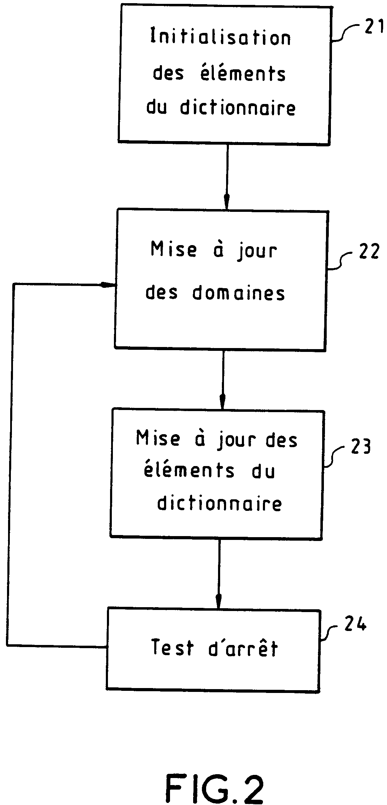

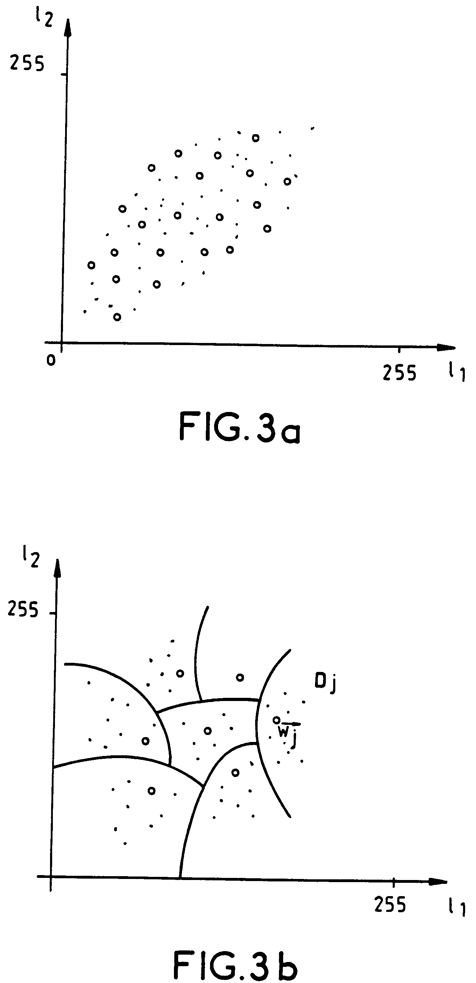

La figure 1 présente un organigramme de la compression d'images selon l'invention. Dans une première étape de quantification vectorielle 1, l'image source 2 est découpée en blocs, chaque bloc est comparé aux éléments du dictionnaire 3 qui s'en rapproche le plus. L'image comprimée est obtenue lorsque tous les blocs de l'image source ont été remplacés par un index. Cette image est l'image des index 4. Le procédé, selon l'invention, utilise une méthode de quantification vectorielle qui conserve à l'image des index 4 une cohérence par rapport à l'image source 2 de façon à pouvoir utiliser cette image des index 4 comme entrée d'une deuxième étape 5 de compression utilisant selon l'invention une méthode de prédiction. A cet égard, et afin d'améliorer la prédiction le procédé utilise dans la première étape 1 un dictionnaire 3 construit selon l'algorithme illustré par la figure 2. L'algorithme commence par une première étape d'initialisation des éléments du dictionnaire 21. Ces éléments sont des blocs choisis de manière aléatoire et sont représentés par des vecteurs. Le dictionnaire 3 peut contenir par exemple M éléments notés $\vec{W}_j$ où j est un indice appartenant aux nombres entiers compris entre 0 et M - 1 inclus. j représente l'index du bloc représenté par le vecteur $\vec{W}_j$, ce bloc est appelé bloc d'index j. Les composantes du vecteur $\vec{W}_j$ sont les luminances des pixels du bloc d'index j. Ces luminances sont par exemple codées sur 8 bits et ont des valeurs comprises entre 0 et 255. La figure 3a représente la projection du lieu géométrique des vecteurs $\overrightarrow{W_j}$ suivant deux composantes associées à deux pixels successifs pris deux à deux dans le sens de balayage de l'image source 2. Les ronds représentent les vecteurs $\overrightarrow{W_j}$ associés aux blocs du dictionnaire et les points les blocs de l'image. Ces blocs sont extraits d'un ensemble d'apprentissage A contenant un grand nombre de blocs extraits d'une ou plusieurs images, sont très nombreux et sont extraits d'une ou plusieurs images. Les axes $I_1$ et $I_2$ indiquent les luminances des deux pixels successifs codés entre 0 et 255. Chaque vecteur $\overrightarrow{W_j}$ génère un domaine $D_j$ comprenant des vecteurs $\overrightarrow{x}$ représentant des blocs de l'ensemble d'apprentissage A précité. La figure 3b représente les domaines $D_j$ associés aux vecteurs $\overrightarrow{W_j}$ ces domaines sont séparés par des traits pleins. Une loi d'initialisation des blocs du dictionnaire 3 peut, par exemple, définir les vecteurs $\overrightarrow{W_j}$ par $W_{ij} = j/2^{ns} + b_{ij}$ où $W_{ij}$ est la composante de rang i du vecteur

$\overrightarrow{W_{j'}}$, ns un nombre entier choisi par exemple de telle sorte que $2^{ns}$ soit égal au nombre de niveaux de gris de l'image source et $b_{ij}$ un bruit de densité uniforme compris par exemple entre -5 et 5. L'étape 21 est suivie d'une étape 22 de mise à jour des domaines précédemment définis. Un domaine $D_k$ associé au vecteur $\overrightarrow{W_k}$ représentant un bloc du dictionnaire 3 d'index k est mis à jour de la manière suivante selon l'algorithme des k - means précédemment cité : chaque nouveau vecteur $\overrightarrow{x}$ appartenant à $D_k$ est déterminé par la relation :

$$\sum_{\ell=0}^{\ell=M-1} \alpha k\ell \left\| \overrightarrow{x} - \overrightarrow{W\ell} \right\|^2 \leq \sum_{\ell=0}^{M-1} \alpha j\ell \left\| \overrightarrow{x} - \overrightarrow{W\ell} \right\|^2$$

quelque soit l'indice j différent de l'indice k.

Les coefficients $\alpha_{k\ell}$, $\alpha_{j\ell}$ relatifs respectivement aux domaines $D_k$ et $D_j$ traduisent les interactions topologiques à l'intérieur du dictionnaire. Un coefficient $\alpha_{jk}$ traduisant les interactions entre le domaine Dj et le domaine Dk est par exemple défini à l'itération t par :

$$\alpha jk_{(t)} = e^{-(j-k)^2 / \sigma_t^2} \quad \text{avec} \quad \sigma_t = \sigma_1 \left( \frac{\sigma T}{\sigma_1} \right)^{t/T}$$

**T** étant le nombre d'itérations totales préalablement déterminé.

$\sigma_1$ correspond à la première itération, il peut prendre par exemple une valeur comprise entre 1 et 10.

$\sigma_T$ correspond à la dernière itération, il peut prendre par exemple une valeur comprise entre 0,1 et 1.

L'étape 22 est suivie d'une étape 23 de mise à jour des éléments du dictionnaire. Un vecteur $\overrightarrow{W_j}$ représentant un bloc d'index j du dictionnaire est mis à jour par la relation :

$$\overrightarrow{W_j} = \frac{\displaystyle\sum_{k=0}^{k=M-1} \alpha jk \; pk \; \overrightarrow{bk}}{\displaystyle\sum_{k=0}^{k=M-1} \alpha jk \; pk}$$

$\alpha jk$ est le coefficient précédemment défini.

$p_k$ est la probabilité qu'un bloc de l'ensemble d'apprentissage ait son vecteur associé $\overrightarrow{x}$ qui appartient à un domaine Dk précédemment défini.

$\overrightarrow{b_k}$ est un vecteur dont l'extrémité représente le barycentre des extrémités des vecteurs du domaine Dk. L'étape 23 est suivie d'une étape de test d'arrêt. Si le nombre d'itérations déjà effectuées est égal au nombre total T accordé, la construction du dictionnaire 3 est achevée. Dans le cas contraire, l'étape 24 est suivie à nouveau de l'étape 22 de mise à jour des domaines. Le nombre total T d'itérations est par exemple égal à quelques centaines et permet d'obtenir des résultats satisfaisants. L'algorithme de constitution du dictionnaire 3 selon l'invention revient en fait à réaliser des mises à jour successives des domaines et des éléments du dictionnaire. Cet algorithme permet avantageusement de converger vers une meilleure définition du dictionnaire. Par ailleurs, les contenus des blocs d'index proches dans le dictionnaire sont presque semblables, cette conservation de la topologie permet de conserver une cohérence de l'image des index 4 par rapport à l'image source 2 et autorise la mise en oeuvre de la seconde étape 5 du procédé selon l'invention de compression de l'image des index 4 suivant une autre méthode de prédiction comme le montre la figure 1. L'opérateur de prédiction peut être par exemple un réseau de neurones multicouches. Un algorithme d'apprentissage permet d'obtenir les coefficients 6 de ce réseau. Pour prédire la valeur de l'index i (x, y) situé dans l'image comprimée à la colonne x et y la ligne y, le réseau de prédiction 5 reçoit en entrée un vecteur élaboré à partir de quatre pixels voisins dans l'image comprimée dont les index sont i (x-1, y-1), i(x, y-1), i(x+1, y-1) et i(x-1, y). La prédiction de i(x, y) obtenue en sortie de la deuxième étape 5 est notée î(x, y). Afin de ne pas induire de perte de qualité, les erreurs de prédiction i(x, y) - î(x, y) sont transmises avec l'index i(x, y) correspondant, à un codeur 8 après une élaboration de cette erreur 7. L'erreur de prédiction peut être par exemple codée suivant un code de HUFFMAN, présenté dans l'ouvrage de Georges CULLMANN "Codage et transmission de l'information" (pp 87-88), Eyrolles, 1968.

La nouvelle image comprimée et codée peut ainsi être stockée dans une mémoire de masse ou transmise par exemple, et cela avec un très bon taux de compression pour une qualité d'image reconstituée satisfaisante.

## Revendications

1. Procédé de compression d'images comprenant une première étape (1) de quantification vectorielle où une image source (2) est découpée en blocs, chaque bloc étant comparé aux éléments d'un dictionnaire (3) en vue de le remplacer par l'index de l'élément du dictionnaire (3) qui s'en rapproche le plus, de manière à obtenir une image comprimée (4) et cohérente par rapport à l'image source (2), cette première étape (1) étant suivie d'une deuxième étape (5) de compression de l'image comprimée suivant une méthode de prédiction, caractérisé en ce que le dictionnaire (3) est construit suivant un algorithme qui réalise des mises à jour successives des éléments du dictionnaire (23) et de domaines (22) associés à ces éléments, ces domaines comprenant des blocs d'images issus d'un ensemble d'apprentissage réalisé à partir d'une ou plusieurs images, les mises à jour des éléments du dictionnaire et des domaines faisant intervenir des intéractions topologiques ($\alpha jk$) qui permettent de conserver la cohérence topologique du dictionnaire.

2. Procédé selon la revendication 1, caractérisé en ce que l'algorithme de construction du dictionnaire (3) réalise les mises à jour suivant un nombre total d'itérations prédéterminé.

3. Procédé selon l'une quelconque des revendications précédentes, caractérisé en ce que le dictionnaire (3) est initialisé avec des éléments choisis de façon aléatoire.

4. Procédé selon l'une quelconque des revendications précédentes, caractérisé en ce que l'étape de prédiction (5) est réalisée suivant un réseau de neurones multicouches.

5. Procédé selon l'une quelconque des revendications précédentes, caractérisé en ce que l'erreur de prédiction (7) est codée suivant un code de HUFFMAN (8).

Image source — 2

1 — Quantification vectorielle

Dictionnaire — 3

4 — Image des index

$i(x,y)$

5 — Prédiction

Coéfficients — 6

$i(x,y)$

$\hat{i}(x,y)$

Elaboration de l'erreur de prédiction — 7

$i(x,y - \hat{i}(x,y))$

$i(x,y)$

8 — Codage

FIG.1

Initialisation
des éléments
du dictionnaire — 21

Mise à jour
des domaines — 22

Mise à jour des
éléments du
dictionnaire — 23

Test d'arrêt — 24

# FIG.2

FIG.3a

FIG.3b

Office européen
des brevets

**RAPPORT DE RECHERCHE EUROPEENNE**

Numero de la demande

EP 92 40 2489
Page 1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-0 280 313 (FUJI PHOTO FILM) * page 7, ligne 25 - page 8, ligne 4 * --- | 1-5 | H04N7/13 H04N7/137 H03M7/30 |
| Y | THE TRANSACTIONS OF THE INSTITUTE OF ELECTRONICS, INFORMATION AND COMM. ENGINEERS vol. E73, no. 9, 30 Septembre 1990, TOKYO pages 1493 - 1502 JUNG ET AL. 'ADAPTIVE VECTOR QUANTIZATION BASED UPON THE UPDATE OF A CODEBOOK FOR IMAGE SEQUENCE CODING' * page 1493, colonne de droite, ligne 33 - page 1496, colonne de gauche, ligne 22 * --- | 1-5 | |
| Y | PATENT ABSTRACTS OF JAPAN vol. 014, no. 451 (E-0984)27 Septembre 1990 ( MATSUSHITA ) 12 Juillet 1990 & JP-A-2 179 166 * abrégé * --- | 4 | |
| A | IEEE TRANSACTIONS ON NEURAL NETWORKS vol. 1, no. 1, 31 Mars 1990, NEW YORK pages 93 - 99 JARI A. KANGAS ET AL. 'VARIANTS OF SELF-ORGANIZING MAPS' * page 95, colonne de gauche, ligne 4 - page 99, colonne de gauche, ligne 39 * --- | 1,4 | **DOMAINES TECHNIQUES RECHERCHES (Int. Cl.5)** H04N H03M |
| D,A | IEEE TRANSACTIONS ON COMMUNICATIONS vol. COM28, no. 1, 31 Janvier 1980, NEW YORK pages 84 - 95 LINDE ET AL. 'AN ALGORITHM FOR VECTOR QUANTIZER DESIGN' --- -/-- | 1 | |

Le présent rapport a été établi pour toutes les revendications

| Lieu de la recherche | Date d'achèvement de la recherche | Examinateur |
|---|---|---|
| LA HAYE | 03 DECEMBRE 1992 | BOSCH F.M.D. |

EPO FORM 1503 03.82 (P0402)

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
............................................................................
& : membre de la même famille, document correspondant

Office européen
des brevets

RAPPORT DE RECHERCHE EUROPEENNE

Numero de la demande

EP    92 40 2489
Page 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | IEEE TRANSACTIONS ON COMMUNICATIONS vol. 36, no. 8, 31 Août 1988, NEW YORK pages 957 - 971 NASRABADI ET AL. 'IMAGE CODING USING VECTOR QUANTIZATION: A REVIEW'<br><br>----- | 1,3,5 | |
| | | | DOMAINES TECHNIQUES RECHERCHES (Int. Cl.5) |

Le présent rapport a été établi pour toutes les revendications

| Lieu de la recherche | Date d'achèvement de la recherche | Examinateur |
|---|---|---|
| LA HAYE | 03 DECEMBRE 1992 | BOSCH F.M.D. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)